# EUROPEAN PATENT APPLICATION

(11) **EP 1 378 948 A1**
(43) Date of publication of application: **07.01.2004**
(21) Application number: 03447176.3
(22) Date of filing: 01.07.2003
(51) Int. Cl.: H01L 31/18, H01L 31/068, H01L 21/306, H01L 21/308

(54) **Semiconductor etching paste and the use thereof for localised etching of semiconductor substrates**

(30) Priority: 01.07.2002 EP 02014524; 27.06.2003 US 609015
(71) Applicant: INTERUNIVERSITAIR MICROELEKTRONICA CENTRUM VZW, 3001 Leuven (BE)
(72) Inventor: Szlufcik, Jozef, 3010 Kessel-Lo (BE); Van Kerschaver, Emmanuel, 3111 Wezemaal (BE); Allebé, Christophe, 1360 Orbais (BE)
(74) Representative: Bird, Ariane

(57) **Abstract**

A method of etching a semiconductor substrate is described , comprising the step of:
applying a paste containing an etchant to the substrate, carrying out a thermal processing step to etch a part or a layer of the substrate where the paste has been applied. The etchant paste is preferably a caustic etching paste. The etchant paste may be applied selectively to a major surface of the substrate to form a pattern of applied paste. For example, the paste may be applied by a printing method, e.g. screen printing.

The method may be used to produce solar cells.

## Description

### FIELD OF THE INVENTION

The present invention relates to a cost-effective method for producing semiconductor devices, especially solar cells as well as the semiconductor devices or cells produced. More particularly the invention is related to a method for forming solar cells on a high-throughput production line. More in particular the present invention relates to methods of etching substrates such as the substrate of a solar cell as well as etchant pastes for use in carrying out the etching method.

### TECHNICAL BACKGROUND

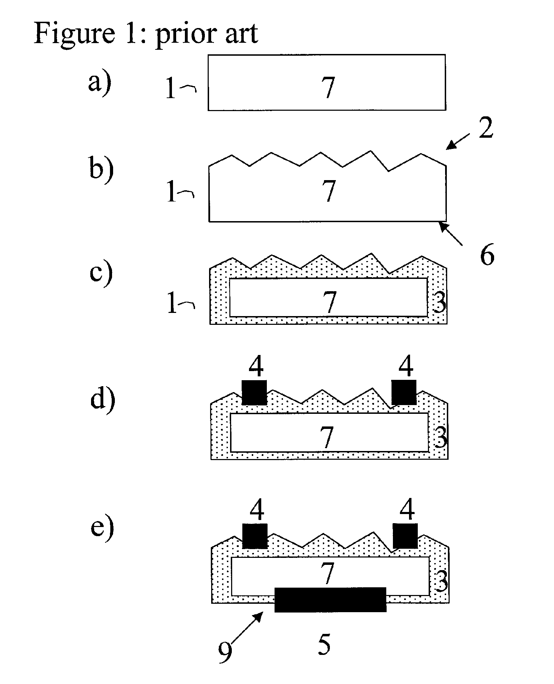

Low or medium efficient solar cells need to be produced in a very efficient way in order to keep the overall costs as low as possible. Such low cost solar cells are typically manufactured in a continuous high throughput production line, in which handling of wafers must be limited to a minimum. The number of process steps should be as low as possible and the process steps must preferably allow such continuous processing without interruption. Examples of such processes are given in European Patent Application 979546694 "Semiconductor device with two selectively diffused regions" and in US 5,726,065 "Method of Preparing Solar Cells Front Contacts". The "front end" process of a solar cell comprises the steps of (see Fig. 1):
- providing a starting semiconductor substrate: typically low cost substrates (1), such as polycrystalline or multi crystalline p-type silicon wafer (Fig. 1a),
- substrate cleaning between different steps,
- surface texturing, e.g. using wet chemicals, to roughen the front surface (2) of the substrate (Fig. 1 b) as disclosed e.g. in EPO773590 "Solar cell comprising multi crystalline silicon and method of texturing the surface of P-type multicrystalline silicon semiconductor,
- forming the emitter region (3) (Fig. 1c), as e.g. described in EP 979546694" Semiconductor device with two selectively diffused regions", byphosphor solid source doping of the wafer in a furnace to form the emitter region (3) and furnace diffusion of the phosphor dopants -etching the phosphoroxide or phosphor-glass formed during the previous phosphorus solid source doping.

The substrate is doped in all surfaces that are exposed to the gaseous environment, not only the front but also the edges, openings in the substrate and the uncovered area's of the back side of the wafer will be doped.

The "back end" process of a solar cell comprises the steps of (see Fig. 1):
- forming contacts (4) to the emitter (3), e.g. by screen printing on the front side (2) a paste comprising metal particles and using a thermal step to sinter these metal particles with the semiconductor substrate, i.e. the firing step as disclosed e.g. in US5698451(Fig. 1d), -forming contacts (5) at the back side (6) of the bulk region (7) which is of a conductivity type e.g. p-type, opposite to the emitter dopant type, e.g. n-type. This can also be done by the screen-printing and firing- technique used for the emitter contacts (Fig. 1e).

The firing step of the emitter-contacts (4) and the back-contacts (5) can be done simultaneously.

A significant problem arising from continuous high throughput solar cell processes is the isolation between the n-type emitter (3) and the p-type collector bulk contacts so that no electrically short circuit of the diode occurs.

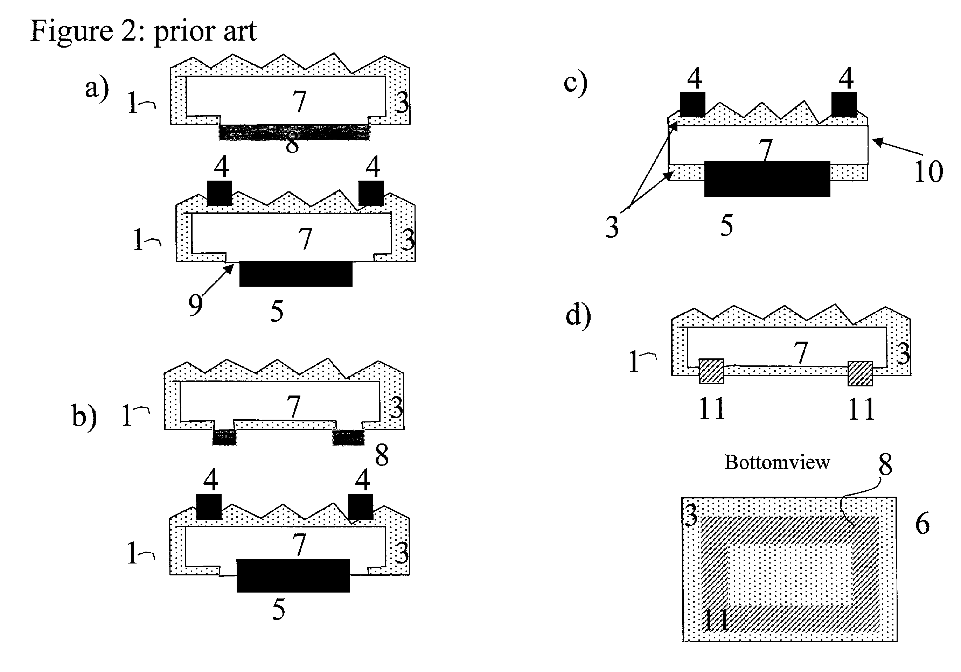

In order to avoid the shunting or short circuiting of the emitter-contacts (4) to the bulk- contacts (5) no overlap (9) over or direct electrical contact between the n-type emitter region (3) and the bulk-contacts (5) is allowed. Various methods are known to prevent such overlap, some of these methods are presented below. These methods can be categorized in patterned and unpatterned methods, depending on whether the separation of the both regions is adjustable, i.e. layout dependent, or fixed, i.e. done by employing a given toolset. Examples of such patterned methods are:
1. During the step of doping the emitter the bulk contact region is masked (8) with a given overlap over the bulk contact region (5) and this part of the surface remains p-type doped. (see Fig. 2a). This masking material needs to be removed without affecting the solar cell. Such an approach is disclosed in EP 979546694 "Semiconductor device with two selectively diffused regions
2. During the emitter doping step the perimeter of the bulk contact region (5) is masked (8). The bulk region itself however will be n-type doped. During subsequent processing of the bulk-contacts a counter-doping is needed, e.g. by the diffusing or alloying with the metal paste, to compensate for this n-type doping within area bordered by the masking perimeter and to convert the contact region (5) into a p-type doped region. (see Fig. 2b) This masking material needs to be removed without affecting the solar cell.
3. Instead of masking the perimeter (8) of the bulk contact region, as disclosed above, a paste can be dispensed as shown in Fig. 2d. This paste (11) can electrically isolate the back side contact (5) from the emitter regions (3) in three ways:
   3.1. During subsequent processing the paste (11) reduces the dopant level of the emitter region underneath the dispensed ring (11). This reduction can be e.g. by removing the n-type dopants in the emitter region located underneath the paste area (11). The paste can e.g. dissolve the semiconductor material of the substrate underneath it, whereby the dopants present in this affected region have another solubility in the dissolved material at the given process temperature than at the temperature at which they were introduced earlier in the process. The excess dopants are absorbed by the paste material. Such a method is disclosed in EP56169378 using a paste that melts the silicon.
   3.2. During subsequent processing the paste (11) counter-dopes the emitter regions underneath the dispensed ring. By alloying the substrate underneath with dopants present in the paste (11) a p-type region is formed extending from the backs surface (6) throughout the emitter region (3) to the bulk region (7). Such a method is disclosed in JP5619378 using an aluminum-based paste for counter-doping.

Examples of unpatterned methods are:
1. In "High throughput laser isolation of crystalline silicon solar cells" by G. Emanuel, 17^{th} European Photovoltaic Solar Energy Conference and Exhibition, Munich, Germany 22-26 October, 2001, a laser technology was applied to isolate the edges of solar cells. The laser scribing evaporates the substrate material on the back surface and hence a groove is formed separating the n-doped surface regions from the contact regions to the p-doped bulk.
2. Sometimes the edges (10) of the wafers are removed. In "a new passivation method for edge shunts of silicon solar cells" by M. Al-Rifai et al., 17^{th} European Photovoltaic Solar Energy Conference and Exhibition, Munich, Germany 22-26 October, 2001, wafers are first stacked. On the edges of this wafer stack a KOH aqueous solution is applied by means of a sponge. Then the wafer stack with the wetted edges is heated up until the reaction temperature of the KOH solution is reached. At this temperature the KOH starts to etch the silicon, thereby removing n-type doped edge regions. A final device according to this method is shown in Fig. 2c. A disadvantage of this technique is that the stacked wafers vary in size, typically about 0.5 mm, and hence not only the edges but also the front and/or back surfaces of the substrate are etched resulting in a smaller active area. Stacked wafers also need additional wafer handling and can cause damage to the substrate surface. The time between applying the KOH aqueous solution and etching the edges should be limited as much as possible to make sure that the etching liquid remains on the substrate and to avoid drying out or evaporating of the etching liquid. This disadvantage is related to the fact that an etching liquid can not be confined to a given area.
   In US 5894853 (Fujisaki Tatsuo et al.), US 5688366 (Ichinose Hirofumi et al.), US 6388187 (Kusakari Masayuki et al.) and US2396043 (Kawakami Soichiro et al.) etching pastes are disclosed for etching transparent conducting films as for instance ITO (Indium Tin Oxide). ITO is considered has a conductive compounds and is not considered in the art as a semiconductor substrate such as silicon or germanium.

### AIM OF THE INVENTION

It is an aim of the present invention to provide semiconductor devices and methods of forming the semiconductor device which etching steps are simplified.

In particular it is an aim of the present invention to provide semiconductor devices and methods of forming these semiconductor devices in which a simpler etching step is used to electrically isolate regions of a semiconductor substrate from each other. The semiconductor device may be a solar cell. Preferably the method only requires one additional step performed on the back side of the substrate, without changing the process complexity or thermal budget.

It is further independent aim of the present invention to provide a new, natural or synthetic etchant material which simplifies etching of patterns into substrates.

### SUMMARY OF THE INVENTION

The present invention, in one aspect, provides a method of etching a substrate, comprising:
applying a paste containing a caustic, e.g. basic or alkaline etchant to the substrate, and carrying out a thermal processing step to etch a part or a layer of the substrate where the paste has been applied.

In a further aspect the present invention provides a method of etching a semiconductor substrate, comprising:
applying a paste containing an etchant to the substrate, and
carrying out a thermal processing step to etch a part or a layer of the substrate where the paste has been applied. The etchant paste is preferably a caustic, e.g. basic or alkaline paste. The etchant paste may be applied selectively to a major surface of the substrate to form a pattern of applied paste. The paste is applied e.g. by a printing method such as e.g. screen printing.

The etchant is preferably applied to a surface doped region of the semiconductor substrate. The doping of a region of the substrate is preferably formed before the paste applying step and the etchant paste may be applied to the doped region of the substrate. The substrate may be part of a solar cell and the doping step may be the formation of an emitter region.

The present invention also provides a solar cell manufactured by the above methods.

The present invention also provides an etchant paste suitable for selective deposition onto a substrate to be etched. The substrate may be a semiconductor substrate. The etchant paste is preferably adapted to be used in a selective deposition method such as screen printing. This adaption may mainly be related to the viscosity of the paste at application temperatures, e.g. at room temperature. The etchant paste should preferably etch the substrate at a high rate only above an elevated temperature e.g. at 50°C or above so that room temperature application does not cause the reaction to start immediately. The etchant paste comprises a caustic, e.g. basic or alkaline etching agent such as potassium hydroxide (KOH), sodium hydroxide (NaOH), ammonium hydroxide (NH₄OH) or combinations or derivatives of these. The etchant paste is preferably water-based. The etchant paste preferably comprises water, a caustic, e.g. basic or alkaline, agent and a thickener to increase the viscosity sufficiently that the paste can be selectively deposited. Such a thickener may be a metal carboxy alkyl cellulose salt such as sodium or potassium carboxy methyl cellulose (Na CMC). Generally, hydro-colloid forming cellulose or starch products or derivatives or physically or chemically modified hydro-colloid forming cellulose or starch products or derivatives are preferred. The modification may be for instance partial or complete cross-linking of the material. The thickener can be natural as for instance also Agar Gum or Xanthan Gum. The advantages of a natural thickener are straight forward since they can be handled more easily with respect to health precautions, can be recycled more easily, safety protection etc.The thickener may also be a completely synthetic material such as strongly hydrolized polyacrylamide gels such as acrylamide/sodium or potassium acrylate copolymer gels. The combination of etching agent, substrate and heat processing conditions may be selected to provide either anisotropic etching or isotropic etching.

### BRIEF DESCRIPTION OF THE DRAWINGS

Figure 1 shows a process flow according to prior art
Figure 2 shows a process according to prior art
Figure 3 shows a process according to an embodiment of the present invention.
Figures 4a and 4b show schematic representations of solar cells made in accordance with embodiments of the present invention.
Figure 5 shows a process flow for manufacture of the solar cell of Fig. 4b.

### DETAILED DESCRIPTION OF THE ILLUSTRATED EMBODIMENTS

The present invention will be described with reference to certain embodiments and drawings but the skilled person will appreciate that the invention as claimed in the attached claims has advantageous use beyond these exemplary embodiments. In particular the present invention will mainly be described with reference to applications in and with solar cells but the presented invention is not limited thereto.

In embodiments of the present invention, the term "substrate" may include any underlying material or materials that may be used, or upon which a device, a circuit or an epitaxial layer may be formed., In embodiments of the present invention, this "substrate" may include a semiconductor substrate such as e.g. a microcrystalline, polycrystaline or amorphous silicon, a doped silicon, a gallium arsenide (GaAs), a gallium arsenide phosphide (GaAsP), a germanium (Ge), or a silicon germanium (SiGe) substrate. The "substrate" may include, for example, an insulating layer such as a SiO₂ or an Si₃N₄ layer in addition to a semiconductor substrate portion. Thus, the term substrate also includes silicon-on-insulator (SOI), silicon-on-glass, silicon-on sapphire (SOS) substrates. The term "substrate" is thus used to define generally the elements for layers that underlie a layer or portions of interest. Also, the "substrate" may be any other base on which a semiconductor layer is formed, for example a glass, ceramic or metal layer. In the following, processing will mainly be described with reference to silicon processing but the skilled person will appreciate that the present invention may be implemented based on other semiconductor material systems. The skilled person can select suitable materials as equivalents of the dielectric and conductive materials described below.

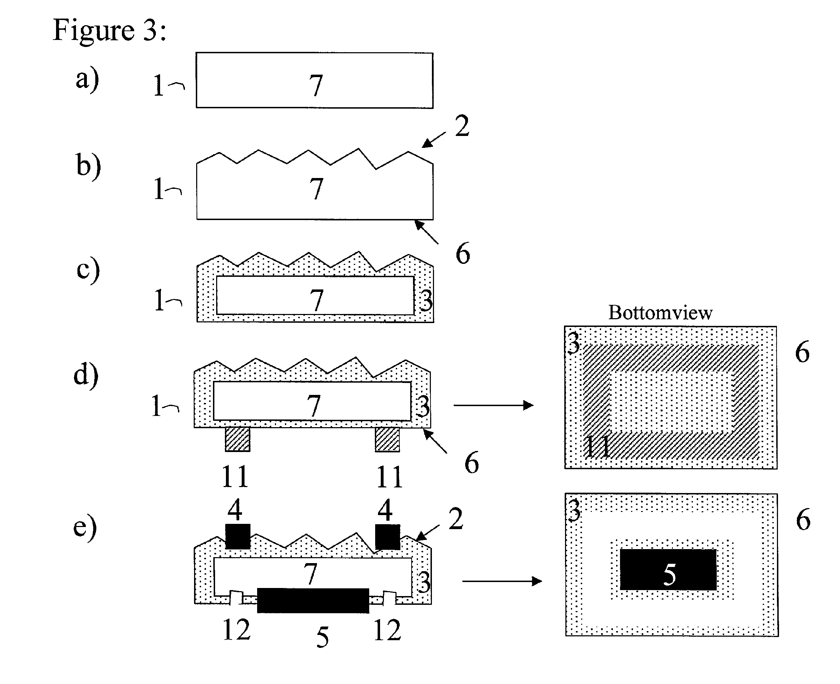

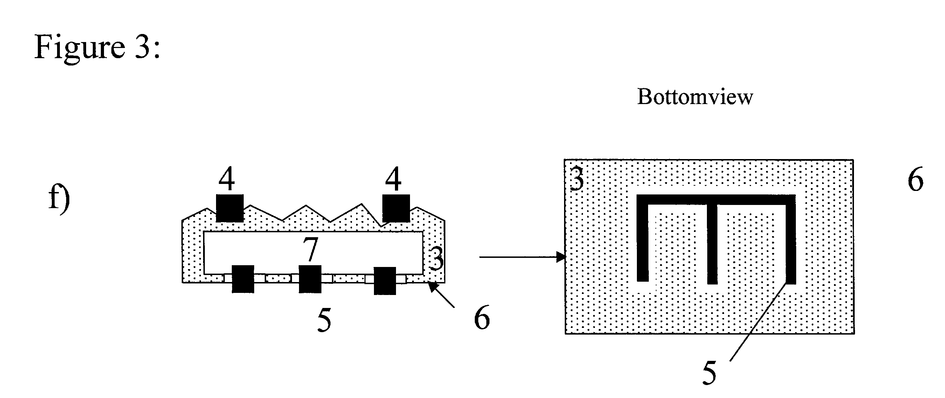

In a first aspect of the invention a method for insulating back contact regions from emitter regions is disclosed, e.g. in a solar cell. A process flow is shown in Fig. 3. Processing steps may comprise front end processing as generally described for Fig. 1:
- providing a starting semiconductor substrate: typically a low cost substrate (1), such as polycrystalline or multi crystalline p-type silicon wafer (Fig. 3a),
- substrate cleaning between different steps,
- surface texturing, e.g. using wet chemicals, to roughen at least the front surface (2) of the substrate (Fig. 3 b), for instance as disclosed in EPO773590 "Solar cell comprising multi crystalline silicon and method of texturing the surface of P-type multicrystalline silicon semiconductor,
- forming the emitter region (3) (Fig. 3c), as e.g. described in EP 979546694 "Semiconductor device with two selectively diffused regions", by: doping the emitter region (3), e.g. by a gaseous or solid source doping step of the wafer using a suitable dopant such as phosphor. Where a solid dopant is used this dopant can be diffused into the substrate using a furnace. The substrate is doped in all surfaces that are exposed to the gaseous environment.
- etching away any residues such as phosphoroxide or phosphor-glass formed during the previous solid source doping step,
- forming contacts (4) to the emitter (3) by any suitable process, e.g. by using a printing process such as screen printing a paste onto the front side (2), the paste comprising metal particles and using a high temperature thermal step to sinter these metal particles with the semiconductor substrate, e.g. carrying out a firing step as disclosed e.g. in US5698451,
- forming contacts (5) at the back side (6) of the bulk region (7) which is of a conductivity type e.g. p-type, opposite to the emitter dopant type, e.g. n-type. This can also be done by a screen-printing and firing technique used for the emitter contacts (Fig. 3e), for example. The firing step of the emitter-contacts (4) and the back-contacts (5) can be done simultaneously.

This embodiment further uses an etching paste that can be dispensed in a controlled way. The paste preferably includes as one component a basic or alkaline caustic agent. The paste or similar may be selectively applied at least to one major surface of the substrate in a defined pattern which may take the form of lines and/or areas. The paste is selectively applied to those regions of the substrate surface where isolation regions are to be formed in a later step. Various techniques may be used to apply the paste selectively to the substrate. Application of the paste is preferably carried out in a very defined and reproducible way. Thick film techniques for applying the metal and/or doping pastes show an excellent repeatability. Preferred techniques have good repeatability such as screen, offset, gravure or ink jet printing or paste writing. The paste is preferably printed onto the substrate by thick film techniques such as screen printing in order to give good repeatability in a high volume production process. It is advantageous to use the same technique for applying dopant paste, etching paste and metal paste. A DEK model 1760RS screen printer may be used to apply one or more of the pastes.

Alternative paste application methods are included within the scope of the present invention. For instance a lift off layer may be applied in a selective pattern on the substrate which is the inverse of the pattern of paste to be applied. The paste is then applied uniformly over the whole are of the substrate. The lift off layer is then removed with the overlying paste to form a pattern of applied paste remaining on the substrate.

The viscosity of the etching paste should be selected so that it may be applied accurately by the appropriate technique, e.g. screen printing, but does not flow or spread significantly on the substrate. The etchant paste preferably has a viscosity which allows it to be applied as a flowable and/or malleable material but which reduces its ability to spread once applied. A thixotropic etchant paste can be advantageous. The viscosity of the etchant paste is preferably high enough to prevent significant lateral flow before or during a subsequent heat treatment step that would lead to significantly wider lines or areas of applied paste than desired. However, a small lateral widening of the lines or areas of paste beyond the intended lines or areas is usually permissible.

Preferably, the paste is heat processed immediately or soon after application to the substrate if lateral spreading of the paste is a problem. In such a case, the patterned substrate is preferably loaded as quickly as possible into an oven in which the viscous paste can be heated. For the heat processing step a Tempress conveyor belt dryer, a DEK infrared belt dryer or similar may be used. The temperature is raised to above 50°C and to preferably between about 50 °C and 150°C to complete the etching step.

A process sequence according to an embodiment of the present invention is illustrated in Fig. 3, especially figs. 3 d), e) and f). On the back side (6) of the substrate (1) the etching paste (11) is dispensed parallel to but outside the perimeter of the region of the back side which will receive the back side contact area (5) (Fig. 3d). The dispensing step may be carried out by any suitable process, e.g. by a printing procedure such as screen printing. This etching paste (11) can be dispensed in the same production line as the one described above. The only additional requirement is an additional screen printing chamber, similar to the chamber used to define the front contacts (4).

The step of dispensing the etching paste (11) can be done after the step of doping the emitter region (3) (Fig. 3c) during which the emitter dopants will diffuse into the substrate (7). In particular the etching paste may be applied in the same step as depositing the metal particle containing paste for the contacts (4, Fig. 3d). This etching paste (11) preferably etches the surface of the substrate in such a manner and to such a depth that it insulates the bulk contact regions (5) from the emitter regions. The steps of dispensing, e.g. by means of screen printing, the etching paste (11) and the etching of the substrate can be done separately. The etching paste can be dispensed e.g. at room temperature or at an elevated temperature which is still low enough that the substrate is essentially not etched by the etching paste. The substrate (7) and the dispensed etching paste (11) can be moved to an annealing or heating chamber in which the etching can take place. Depending on the properties of the paste the time between the dispensing and the heating can be selected as desired, e.g. minutes, hours or days. If the paste is applied in a similar manner to that of the metal paste described above, similar tools can be used for dispensing of the paste and for wafer handling. When the glass residues, resulting from the doping of the emitter, are etched off, the etching paste can be also be removed. This removal is preferably done at room temperature. For instance, the substrate may be rinsed with water so that the residues of the etching paste are diluted and are not reactive enough to etch the substrate.

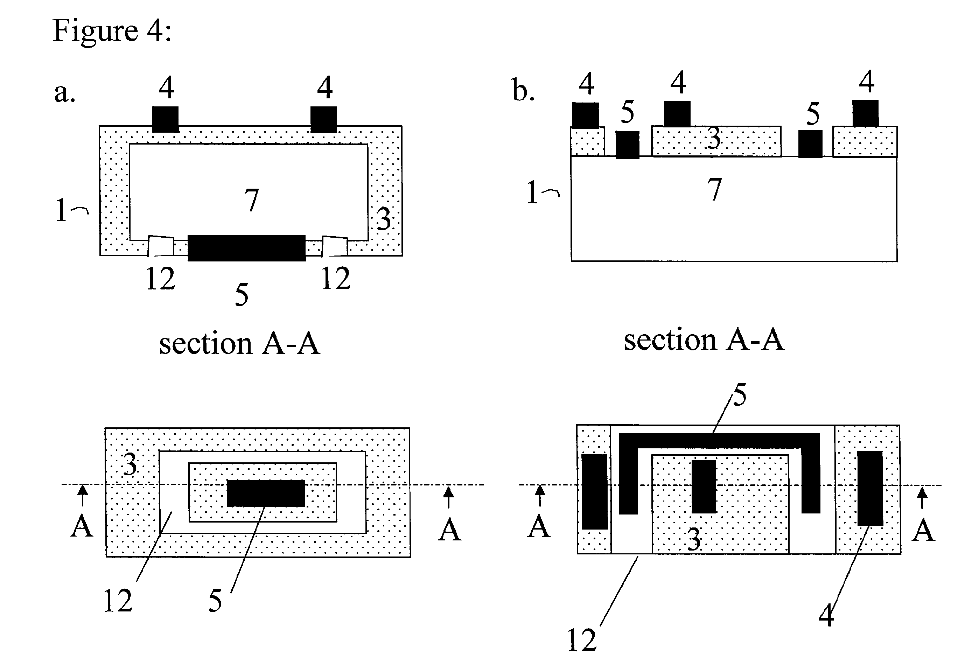

Figs 4a and 4b show a schematic cross-section A-A and a topview of two solar cell devices fabricated according to a further embodiment of the present invention. The solar cell device shown in figure 4a has the contacts (4) to the emitter region (3) at a first main surface of the substrate (1). The emitter region ((3) may be formed in all surfaces of the substrate (1). The emitter region is interrupted at the surface opposite the first main surface, by selectively applying the etching paste, at a first temperature, as described in previous embodiments of the invention and etching at a second elevated temperature resulting in trenches (12) etched into the substrate (1). Typically, the first temperature will be room temperature, i.e. between 15 and 30°C. Within the area bordered by the trenches (12) contacts (5) to the bulk region (7) can be made. These contacts (5) extend throughout the emitter region (3) into the bulk region (7).

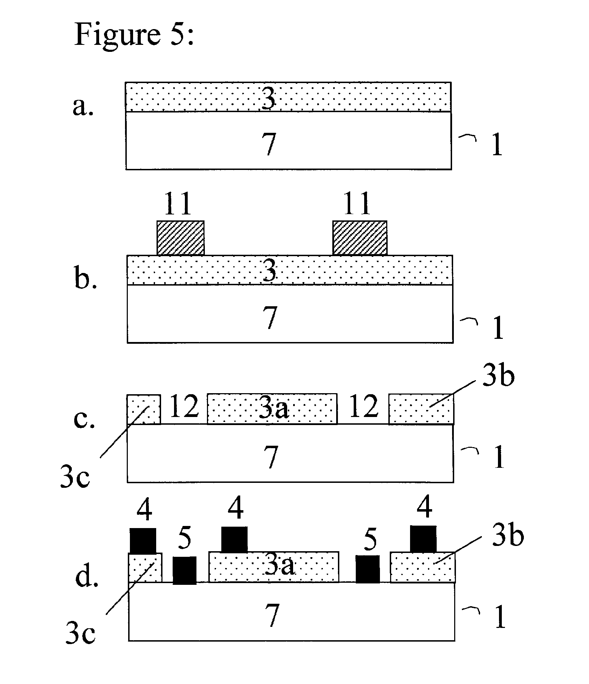

The solar cell device shown in figure 4b has the contacts to emitter region (3) and to the bulk region (7) at the same main surface of the substrate (1). Figure 5 describes a process flow, which yields such a device. In figure 5a first only a first main surface is doped to form an emitter region (3) or layer in the substrate (1). The continuous emitter region (3) is interrupted and divided in separated regions (3a, 3b, 3c) by selectively applying the etching paste (11) to the surface comprising the emitter region (3). Trenches (12) are etched in the semiconductor substrate (1) from the first main surface onwards throughout the emitter region (3). Within these trenches contacts (5) are formed to the exposed bulk region, while contacts (4) are also made to the isolated emitter regions (3).

In all the above embodiments an etching paste is selectively applied on to a surface doped region of a semiconductor substrate and a heat treating step is carried out to etch through the surface region and to thereby isolate regions on one side of the etched region from regions on the other side. In particular in a solar cell this etch isolates an electrode from the emitter region. In particular the isolated electrode is a contact for a bulk region of the substrate.

The etching paste can be used to etch any shape into the substrate. For example it can be used to etch only near the edges of the wafer as shown in Fig. 3d by selective application of the etching paste near the edges. In this case the etching paste is applied to edges of the solar cell structure. If a more complex back side contacting structure is used, as is e.g. done in US 6384317 "SOLAR CELL AND PROCESS OF MANUFACTURING THE SAME" the paste can be applied in a pattern corresponding to the pattern of the back contact region as shown in Fig. 3f.

In another aspect of the invention an etching paste is disclosed. This etching paste can be formulated to etch a semiconductor substrate, e.g. silicon. The etching paste preferably comprises at least one etching agent and a suitable viscosity enhancing agent such as a thickening agent or thickener. Such a thickener may be a metal carboxy alkyl cellulose salt such as sodium or potassium carboxymethyl cellulose. Generally, hydro-colloid forming cellulose or starch products or derivatives or physically or chemically modified hydro-colloid forming cellulose or starch products or derivatives are preferred. The modification may be for instance partial or complete cross-linking of the material. The thickener may be a completely synthetic material such as strongly hydrolized polyacrylamide gels such as acrylamide/sodium or potassium acrylate copolymer gels, see for instance US 4,605,689. The composition may also include other elements such as an extender or a thixotropic agent or may have thixotropic properties intrinsically.

The etching agent can be an aqueous solution of an etchant capable of etching a semiconductor substrate. The etching agent can be caustic in nature, e.g. basic or alkaline. For example, the etching agent can be a solution of a hydroxide such a hydroxide of a metal (e.g. of a light metal such as an alkali metal), such as KOH, NaOH, CeOH, RbOH. The etching agent can also be a non-metal hydroxide such as NH₄OH, (CH₃)₄OH both of which have the advantage that they do not contain a metal ion. The etching agent may also comprise a mixture of any of the agents mentioned above. All such etching agents can be alkaline or basic.

Preferable properties of the etching agent are:
- that it is water-based (because of this allows selection of a wide range of thickeners),
- that it has a reaction/etching temperature of the substrate to be etched above room temperature or application temperature to allow clean separation of the dispensing step and the etching step,
- that it is suitable for use in a selective deposition method such as screen printing or another printing method,
- that it etches the relevant substrate, e.g. a semiconductor substrate, for instance at least one of Silicon, Germanium and Gallium Arsenide, especially amorphous, microcrystalline or polycrystalline silicon.

A referable requirement for the thickener is that it binds water based etching solutions to thereby increase the viscosity to such a level that a paste is formed. Further it should be inert with respect to the caustic etching agent or to react slowly enough that it does not affect the etching process.

In a preferred embodiment of the invention the etching agent is KOH or another hydroxide and the thickener is sodium carboxy methyl cellulose. This thickener is used in food and pharmaceutical applications to bind aqueous solutions and to create e.g. gels. A suitable composition comprises 10 to 15% by weight of KOH in water and 1 to 5% by weight of the thickener, the remaining percentage being water. The substrate to be etched is a silicon substrate. KOH, also known as caustic potash, lye, is a caustic white solid which used as a bleach and in the manufacture of soaps, dyes, alkaline batteries, and many potassium compounds. Methylcellulose is a powdery substance prepared synthetically by the methylation of natural cellulose and used as a food additive, a bulk-forming laxative, an emulsifier, and a thickener. It swells in water to form a gel.

In another embodiment of the invention the etching agent is NaOH, sodium hydroxide, a white opaque brittle solid, having a fibrous structure. Called also sodium hydrate, and caustic soda and by extension, a solution of sodium hydroxide may be used.

The following results illustrate the effectiveness of an alkaline caustic etching paste according to the present invention, for instance, a KOH paste according to a specific embodiment of the present invention, to provide junction isolation over a large number of wafers (20), with plasma etching as a comparative method.

An amount of 150ml of a 50% KOH solution has been mixed with 3g of Na Carboxy Methyl Cellulose (CMC) (Molecular Weight (MW) 25.10⁴ g/mole, degree of substitution (D.S.) 0.7) to obtain a paste. The paste ability to etch the emitter has been studied at for instance a temperature of 95°C.

On non-metallised "cells", dark current-voltage (IV) measurements indicate that KOH etching is preferred compared to plasma etching as a method for junction isolation. The increase of forced current is smaller with increasing reverse voltage. On finished cells, a maximum FF for plasma etching of 75.6% has been achieved, while the use of the KOH etching paste led to a FF of 76.4%.

This shows that an at least equally good level of junction isolation can be reached using KOH paste compared to plasma etching.

It was also found that better ideality factors can be obtained using KOH etching.

While the invention has been shown and described with reference to preferred embodiments, it will be understood by those skilled in the art that various changes are modifications in form and detail may be made without departing from the scope and spirit of this invention. For example, the etching step described above has been applied to a solar cell, however other applications are included within the scope of the present invention, e.g. during CMOS post processing. Also, the etching need not be of the substrate itself but may be of a layer applied to the substrate, e.g. a metal layer, an oxide layer, a nitride layer, etc. The etching paste may be selected to provide anisotropic or isotropic etching.

## Claims

1. A method of etching a semiconductor substrate, comprising:
applying a paste containing an etchant to the substrate,
carrying out a thermal processing step to etch a part or a layer of the substrate where the paste has been applied.

2. The method according to claim 1, wherein the etchant paste is a caustic etching paste.

3. The method according to claim for 2, wherein said etchant paste is basic or alkaline.

4. The method according to any of the claims 1 to 3, wherein said etchant paste is a natural or synthetic etching paste.

5. The method according to any of the claims 1 to 4, wherein said semiconductor substrate comprises microcrystalline, polycrystaline or amorphous silicon, a doped silicon, a gallium arsenide (GaAs), a gallium arsenide phosphide (GaAsP), a germanium (Ge), or a silicon germanium (SiGe).

6. The method according to any of the claims 1 to 5, wherein the etchant paste is applied selectively to a major surface of the substrate to form a pattern of applied paste.

7. The method of any of the claims 1 to 6, wherein the paste is applied by a selective deposition method.

8. The method of claim 7, wherein the selective deposition method is screen printing.

9. The method according to any previous claim, further comprising:
doping a region of the substrate before the paste applying step and applying the etchant paste to the doped region of the substrate.

10. The method according to claim 9, wherein, the substrate is part of a solar cell and the doped region is the emitter region of the solar cell.

11. The method according to any previous claim, wherein substrate has major surfaces and edges and the etchant paste is applied at least to edges of the substrate.

12. The method according to any previous claim, further comprising the step of forming metal contacts on a base region and an emitter region of the substrate.

13. The method according to claim 12 as dependent on claim 10 or 11, wherein the thermal processing step provides an insulating region, the insulating region being provided between the emitter region and a base region to isolate a metal contact from an emitter region.

14. A solar cell manufactured by a process in accordance with any of claims 1 to 13.

15. An etchant paste suitable for deposition on a substrate and suitable for selective etching of a semiconductor substrate, comprising: a solvent and a caustic etching agent which is basic or alkaline.

16. The etchant paste according to claim 15, further comprising a thickener.

17. The etchant paste according to claim 15 or 16, wherein the etchant is selected from one of potassium hydroxide (KOH), sodium hydroxide (NaOH), ammonium hydroxide (NH₄OH) or combinations or derivatives of these.

18. The etchant paste according to any of the claims 15 to 17, wherein the solvent is water.

19. The etchant paste according to any of the claims 15 to 18, wherein the thickener is selected from a metal carboxy alkyl cellulose salt, hydro-colloid forming cellulose or starch products or derivatives or physically or chemically modified hydro-colloid forming cellulose or starch products or derivatives and a strongly hydrolized polyacrylamide gel.
